# EUROPEAN PATENT APPLICATION

(11) **EP 4 603 849 A1**
(43) Date of publication of application: **20.08.2025**
(21) Application number: 24869538.9
(22) Date of filing: 09.01.2024
(51) Int. Cl.: G01R 31/12, G01R 31/385

(54) **INSULATION WITHSTAND VOLTAGE TESTING METHOD AND SYSTEM FOR BATTERY**

(30) Priority: 25.09.2023 CN 202311240820
(71) Applicant: Contemporary Amperex Technology (Hong Kong) Limited, Central (HK)
(72) Inventor: ZHAO, Jiasheng, Ningde, Fujian 352100 (CN); LIAN, Dengwei, Ningde, Fujian 352100 (CN); HAO, Pengfei, Ningde, Fujian 352100 (CN); LI, Yanghu, Ningde, Fujian 352100 (CN)
(74) Representative: Ran, Handong
(86) International application number: PCT/CN2024/071308
(87) International publication number: WO 2025/065966

(57) **Abstract**

This disclosure provides an insulation withstand voltage testing method and system for a battery. The method includes: applying, by a voltage applying device, a direct-current voltage from a zero voltage to a target voltage to a battery cell under test in a first preset time period by using a voltage applying circuit in response to a testing start signal; obtaining a first current value that is generated by the battery cell under test based on the direct-current voltage in the first preset time period; continuously applying, by the voltage applying device, the direct-current voltage of the target voltage to the battery cell under test in a second preset time period by using the voltage applying circuit; obtaining a second current value that is generated by the battery cell under test based on the direct-current voltage in the second preset time period; and if the first current value is less than a first preset current threshold, and the second current value is less than a second preset current threshold, determining, by the voltage applying device, that a testing result of the battery cell under test is passing insulation withstand voltage testing of this time.

## Description

### CROSS-REFERENCE TO RELATED APPLICATIONS

This disclosure claims priority to Chinese Patent Application No. 202311240820.3, filed on September 25, 2023 and entitled "INSULATION WITHSTAND VOLTAGE TESTING METHOD AND SYSTEM FOR BATTERY", which is incorporated herein by reference in its entirety.

### TECHNICAL FIELD

This disclosure relates to, but is not limited to, the technical field of battery testing, and in particular to an insulation withstand voltage testing method and system for a battery.

### BACKGROUND

New energy batteries are more and more widely applied in life and industry. For example, new energy vehicles equipped with batteries have been widely used. In addition, batteries are increasingly applied in fields such as energy storage.

Currently, after production and assembly of a battery pack, insulation withstand voltage testing needs to be performed on the whole pack to ensure electrical safety.

In the prior art, insulation withstand voltage testing is performed by gradually applying a voltage to the battery pack. However, voltage applying duration in this manner is relatively long, which results in low testing efficiency.

### SUMMARY

Embodiments of this disclosure provide an insulation withstand voltage testing method and system for a battery.

The technical solutions of the embodiments of this disclosure are implemented as follows.

An embodiment of this disclosure provides an insulation withstand voltage testing method for a battery. The method includes:
applying, by a voltage applying device, a direct-current voltage from a zero voltage to a target voltage to a battery cell under test in a first preset time period by using a voltage applying circuit in response to a testing start signal; and obtaining a first current value that is generated by the battery cell under test based on the direct-current voltage in the first preset time period;
continuously applying, by the voltage applying device, the direct-current voltage of the target voltage to the battery cell under test in a second preset time period by using the voltage applying circuit; and obtaining a second current value that is generated by the battery cell under test based on the direct-current voltage in the second preset time period, where the second preset time period is a time period subsequent to the first preset time period; and
if the first current value is less than a first preset current threshold, and the second current value is less than a second preset current threshold, determining, by the voltage applying device, that a testing result of the battery cell under test is passing insulation withstand voltage testing of this time;
where the voltage applying device is connected to a test terminal corresponding to the battery cell under test by using the voltage applying circuit; and the voltage applying circuit, the voltage applying device, and the battery cell under test form a circuit loop.

In this embodiment of this disclosure, the current value that is generated by the battery cell under test based on the direct-current voltage is monitored in a process of applying a voltage to the battery cell under test, so that the voltage can be raised, in relatively short duration, to the target voltage required for a withstand voltage test, thereby improving efficiency of insulation withstand voltage testing on the battery.

An embodiment of this disclosure provides an insulation withstand voltage testing system for a battery, including an insulation withstand voltage testing circuit and a voltage applying device. The insulation withstand voltage testing circuit includes a voltage applying circuit, where
the voltage applying device is connected to a test terminal corresponding to a battery cell under test by using the voltage applying circuit;
the voltage applying circuit is configured to: in response to a first testing signal, connect the voltage applying device to the test terminal corresponding to the battery cell under test; and
the voltage applying device is configured to: apply a direct-current voltage from a zero voltage to a target voltage to the battery cell under test in a first preset time period by using the voltage applying circuit in response to a testing start signal; obtain a first current value that is generated by the battery cell under test based on the direct-current voltage in the first preset time period; continuously apply the direct-current voltage of the target voltage to the battery cell under test in a second preset time period by using the voltage applying circuit; obtain a second current value that is generated by the battery cell under test based on the direct-current voltage in the second preset time period, where the second preset time period is a time period subsequent to the first preset time period; and if the first current value is less than a first preset current threshold, and the second current value is less than a second preset current threshold, determine that a testing result of the battery cell under test is passing insulation withstand voltage testing of this time.

In this embodiment of this disclosure, the voltage applying device monitors, by using the voltage applying circuit, the current value that is generated by the battery cell under test in a voltage applying process, which can reduce voltage applying duration in a process of insulation withstand voltage testing for the battery, thereby improving testing efficiency of insulation withstand voltage testing.

In the embodiments of this disclosure, in a process of performing a withstand voltage test on the battery cell under test, usually, the battery cell under test has an instant current of an extreme value at times when a voltage value is relatively small, and therefore it is possible to cause erroneous judgement of insulation withstand voltage testing. In order to avoid this situation, in a conventional voltage raising process, the voltage is slowly raised to reach a target voltage required for the withstand voltage test, and voltage raising needs a relatively long time. On this basis, in this technical solution, the current value that is generated by the battery cell under test based on the direct-current voltage is monitored in a process of applying a voltage to the battery cell under test, so that the voltage can be raised, in relatively short duration, to the target voltage required for the withstand voltage test, and voltage raising duration is reduced, thereby improving efficiency of insulation withstand voltage testing.

It is to be understood that both the foregoing general description and the following detailed description are exemplary and explanatory only and are not restrictive of this disclosure.

### BRIEF DESCRIPTION OF DRAWINGS

The accompanying drawings, which are incorporated in and constitute a part of this specification, illustrate embodiments consistent with this disclosure and together with the description, serve to explain the technical solutions of this disclosure.
FIG. 1 is a schematic composition diagram of an insulation withstand voltage testing system for a battery according to an embodiment of this disclosure;
FIG. 2 is a schematic diagram of an implementation flow of an insulation withstand voltage testing method for a battery according to an embodiment of this disclosure;
FIG. 3 is a schematic diagram of an example of an insulation withstand voltage testing process according to an embodiment of this disclosure;
FIG. 4 is a schematic diagram of an implementation flow of an example of an insulation withstand voltage testing method for a battery according to an embodiment of this disclosure;
FIG. 5 is a schematic flow diagram of an example of an insulation withstand voltage testing process according to an embodiment of this disclosure;
FIG. 6 is a first schematic composition diagram of an example of an insulation withstand voltage testing system for a battery according to an embodiment of this disclosure;
FIG. 7 is a second schematic composition diagram of an example of an insulation withstand voltage testing system for a battery according to an embodiment of this disclosure;
FIG. 8 is an equivalent circuit diagram of an example of insulation withstand voltage testing according to an embodiment of this disclosure;
FIG. 9 is a schematic composition diagram of an insulation withstand voltage testing circuit according to an embodiment of this disclosure;
FIG. 10 is a first schematic composition diagram of an example of an insulation withstand voltage testing circuit according to an embodiment of this disclosure;
FIG. 11 is a second schematic composition diagram of an example of an insulation withstand voltage testing circuit according to an embodiment of this disclosure;
FIG. 12 is a third schematic composition diagram of an example of an insulation withstand voltage testing circuit according to an embodiment of this disclosure; and
FIG. 13 is a fourth schematic composition diagram of an example of an insulation withstand voltage testing circuit according to an embodiment of this disclosure.

### Description of reference signs:

1: insulation withstand voltage testing system for a battery; 10: voltage applying device; 11: voltage applying circuit; 1100: first voltage applying channel; 1101: second voltage applying channel; 111: first switch array; 12: discharging resistor; 13: discharging circuit; 1300: first discharging channel; 1301: second discharging channel; 131: second switch array; 14: voltage testing device;
2: battery cell under test; 20: first test terminal corresponding to a positive electrode of the battery cell under test; 21: second test terminal corresponding to a negative electrode of the battery cell under test;
3: insulation withstand voltage testing circuit; 31: current value; 32: direct-current voltage; and 33: resistance value of the battery cell under test.

### DESCRIPTION OF EMBODIMENTS

To make the purpose, technical solutions and advantages of this disclosure clearer, this disclosure will be further described in detail below in conjunction with the accompanying drawings. The described embodiments should not be regarded as limitations to this disclosure, and all other embodiments obtained by persons of ordinary skill in the art without creative efforts are within the protection scope of this disclosure.

In the following description, some related embodiments describe a subset of all possible embodiments. However, it may be understood that these embodiments may be the same subset or different subsets of all the possible embodiments, and may be combined with each other without conflict.

In the following description, the terms "first/second/third" are merely intended to distinguish between similar objects rather than describing specific orders. It may be understood that, "first/second/third" is interchangeable in proper circumstances to enable the described embodiments of this disclosure to be implemented in other orders than those illustrated or described herein.

Unless otherwise defined, meanings of all technical and scientific terms used in this specification are the same as those usually understood by a person skilled in the art to which this disclosure belongs. Terms used in the specification are merely intended to describe objectives of the embodiments of this disclosure, but are not intended to limit this disclosure.

Currently, new energy batteries are more and more widely applied in life and industry. New energy batteries have been used in energy storage power supply systems such as hydroelectric power plants, thermal power plants, wind power plants, and solar power plants, as well as in many other fields including electric transportation tools such as electric bicycles, electric motorcycles, and electric vehicles, and aerospace. With the continuous expansion of application fields of traction batteries, market demands for traction batteries are also increasing.

In the embodiments of this disclosure, a battery may be a battery cell, or may be a battery module or a battery pack including a plurality of battery cells. A battery cell is a basic unit that can realize mutual conversion between chemical energy and electric energy, and can be used to make battery modules or battery packs, so as to supply power to an electric device. The battery cell may be a secondary battery, and the secondary battery is a battery cell that can activate an active material in a charging manner and continue to be used after the battery cell is discharged. The battery cell may be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, and a lead storage battery. This is not limited in the embodiments of this disclosure.

Currently, after production and assembly of a battery pack, insulation withstand voltage testing needs to be performed on the whole pack to ensure electrical safety. However, in the prior art, insulation withstand voltage testing is performed on the battery pack by applying a voltage to the battery pack gradually to a preset voltage and then gradually decreasing the voltage. However, voltage applying duration and voltage decreasing duration in this manner are relatively long, which results in low testing efficiency.

Based on the above problem, the embodiments of this disclosure provide an insulation withstand voltage testing method and system for a battery, which can reduce voltage applying duration and voltage decreasing duration in a process of insulation withstand voltage testing for a battery pack, thereby improving testing efficiency of insulation withstand voltage testing.

The following will clearly and completely describe the technical solutions in the embodiments of this disclosure with reference to the accompanying drawings in the embodiments of this disclosure.

The insulation withstand voltage testing method for a battery provided in the embodiments of this disclosure is applied to a voltage applying device in an insulation withstand voltage testing system for a battery. Therefore, to better understand the method provided in the embodiments of this disclosure, the following describes the insulation withstand voltage testing system for a battery.

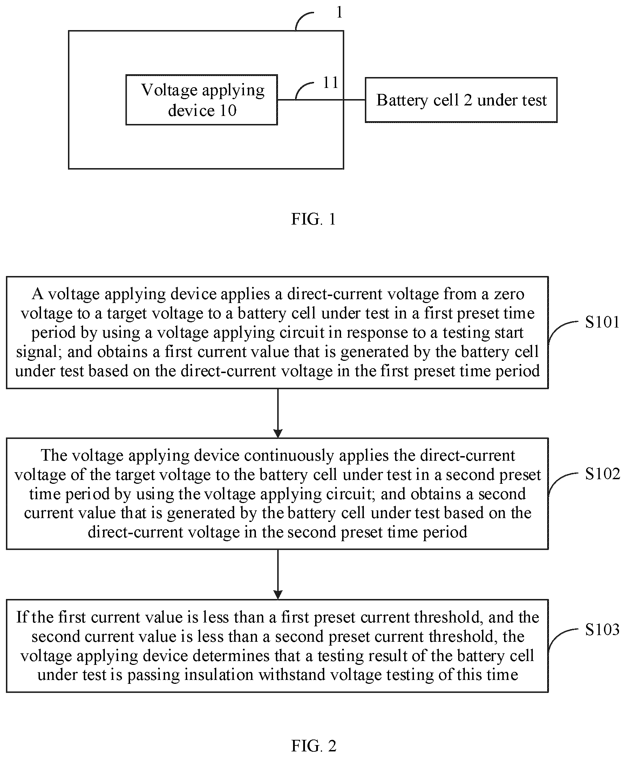

FIG. 1 is a schematic composition diagram of an insulation withstand voltage testing system for a battery according to an embodiment of this disclosure. As shown in FIG. 1, an insulation withstand voltage testing system 1 for a battery includes an insulation withstand voltage testing circuit and a voltage applying device 10. The insulation withstand voltage testing circuit includes a voltage applying circuit 11. The voltage applying device 10 is connected to a test terminal corresponding to a battery cell 2 under test by using the voltage applying circuit 11. The voltage applying circuit 11, the voltage applying device 10, and the battery cell 2 under test form a circuit loop.

FIG. 2 is a schematic diagram of an implementation flow of an insulation withstand voltage testing method for a battery according to an embodiment of this disclosure. The method is applied to a voltage applying device in an insulation withstand voltage testing system for a battery. As shown in FIG. 2, the insulation withstand voltage testing method for a battery includes step S101 to step S103.

Step S101: A voltage applying device applies a direct-current voltage from a zero voltage to a target voltage to a battery cell under test in a first preset time period by using a voltage applying circuit in response to a testing start signal; and obtains a first current value that is generated by the battery cell under test based on the direct-current voltage in the first preset time period.

In this embodiment of this disclosure, the testing start signal may be sent by an upper computer or a programmable logic controller (Programmable Logic Controller, PLC) to the voltage applying device. After receiving the testing start signal, the voltage applying device applies the direct-current voltage from the zero voltage to the target voltage to the battery cell under test in the first preset time period by using the voltage applying circuit; and obtains the first current value that is generated by the battery cell under test based on the direct-current voltage in the first preset time period.

In this embodiment of this disclosure, the voltage applying device is a device that can provide a voltage, and may be an insulation withstand voltage tester. The voltage applying device may be determined depending on an actual situation, and is not specifically limited in this embodiment of this disclosure.

In this embodiment of this disclosure, the insulation withstand voltage testing is to provide a direct-current voltage for the battery cell under test, and decrease the direct-current voltage to zero after the direct-current voltage is maintained for a period of time.

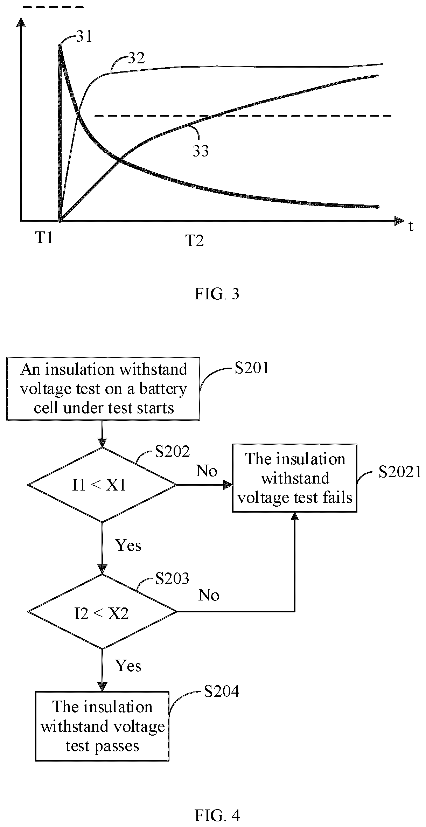

FIG. 3 is a schematic diagram of an example of an insulation withstand voltage testing process according to an embodiment of this disclosure. As shown in FIG. 3, 31 indicates a current value, 32 indicates a direct-current voltage, 33 indicates a resistance value of a battery cell under test, and a first preset time period T1 is duration required for raising a direct-current voltage provided by a voltage applying device for a battery cell under test from zero to a target voltage, namely, is a voltage raising phase. In this case, based on an insulation withstand voltage characteristic of the battery cell under test, a current of the battery cell under test is extremely large when a relatively small direct-current voltage is provided for the battery cell under test, and usually there is an instant current of an extreme value. Therefore, a first current value of the battery cell under test in the first preset time period needs to be monitored, and is tested by using a dashed line corresponding to phase T1 in FIG. 3.

For example, usually, when the voltage applying device applies a direct-current voltage to the battery cell under test, the direct-current voltage is increased, within 10s, from zero to the target voltage, for example, 2700 V. Because voltage raising duration is relatively sufficient, the direct-current voltage is slowly raised to the target voltage, and a current value of the battery cell under test in the voltage raising phase does not need to be monitored. However, when the voltage applying device in this disclosure applies a direct-current voltage to the battery cell under test, the direct-current voltage is raised from zero to the target voltage, for example, 2700 V, within the first preset time period, for example, 2s. Because duration for raising the direct-current voltage is shortened, a current value of the battery cell under test in the voltage raising phase needs to be monitored. The first preset time period and the target voltage may be set depending on an actual situation, and are not specifically limited in this embodiment of this disclosure.

Step S102: The voltage applying device continuously applies the direct-current voltage of the target voltage to the battery cell under test in a second preset time period by using the voltage applying circuit; and obtains a second current value that is generated by the battery cell under test based on the direct-current voltage in the second preset time period.

In this embodiment of this disclosure, the voltage applying device continuously applies the direct-current voltage of the target voltage to the battery cell under test in the second preset time period, where the second preset time period is a time period subsequent to the first preset time period; and obtains the second current value that is generated by the battery cell under test based on the direct-current voltage in the second preset time period.

In this embodiment of this disclosure, as shown in FIG. 3, the second preset time period T2 is duration in which the voltage applying device continuously provides the target voltage for the battery cell under test, namely, is a voltage maintenance phase. In this case, the second current value of the battery cell under test in the second preset time period needs to be monitored, and is tested by using a dashed line corresponding to phase T2 in FIG. 3. The first preset time period is less than the second preset time period.

Step S103: If the first current value is less than a first preset current threshold, and the second current value is less than a second preset current threshold, the voltage applying device determines that a testing result of the battery cell under test is passing insulation withstand voltage testing of this time.

In this embodiment of this disclosure, if the first current value is less than the first preset current threshold, and the second current value is less than the second preset current threshold, the voltage applying device determines that the testing result of the battery cell under test is passing insulation withstand voltage testing of this time.

In this embodiment of this disclosure, FIG. 4 is a schematic diagram of an implementation flow of an example of an insulation withstand voltage testing method for a battery according to an embodiment of this disclosure. As shown in FIG. 4, the method includes the following steps.

Step S201: An insulation withstand voltage test on a battery cell under test starts.

Step S202: Determine whether I1 is less than X1, and if no, go to step S2021; or if yes, go to step S203.

Usually, when a relatively small direct-current voltage, for example, 1000 V, is applied to the battery cell under test, a current generated does not exceed 1 mA. Therefore, a first preset current threshold X1 may be set to 1 mA. Therefore, if a first current value I1 of the battery cell under test in a first preset time period remains less than 1 mA, it indicates that the battery cell under test does not fail in a voltage raising phase, and the withstand voltage test in the first preset time period passes. The first preset current threshold may be set depending on an actual situation, and is not specifically limited in this embodiment of this disclosure.

Step S2021: The insulation withstand voltage test fails.

Herein, if the first current value I1 of the battery cell under test in the first preset time period is greater than 1 mA, it indicates that the battery cell under test fails in the voltage raising phase, and the insulation withstand voltage test in the first preset time period fails.

Step S203: Determine whether I2 is less than X2, and if no, go to step S2021; or if yes, go to step S204.

Usually, when a constant direct-current voltage, for example, 2700 V, is applied to the battery cell under test, a current generated does not exceed 0.01 mA. Therefore, a second preset current threshold X2 may be set to 0.01 mA. Therefore, if a second current value I2 of the battery cell under test in a second preset time period remains less than 0.01 mA, it indicates that the battery cell under test does not fail in a voltage maintenance phase, and the withstand voltage test in the second preset time period passes. The second preset time period and the second preset current threshold may be set depending on an actual situation, and are not specifically limited in this embodiment of this disclosure.

Step S2021: The insulation withstand voltage test fails.

Herein, if the second current value I2 of the battery cell under test in the second preset time period is greater than 1 mA, it indicates that the battery cell under test fails in the voltage maintenance phase, and the insulation withstand voltage test in the second preset time period fails.

Step S204: The insulation withstand voltage test passes.

Herein, if the first current value I1 of the battery cell under test in the first preset time period remains less than 1 mA, and the second current value I2 of the battery cell under test in the second preset time period remains less than 0.01 mA, the insulation withstand voltage test of the battery cell under test passes.

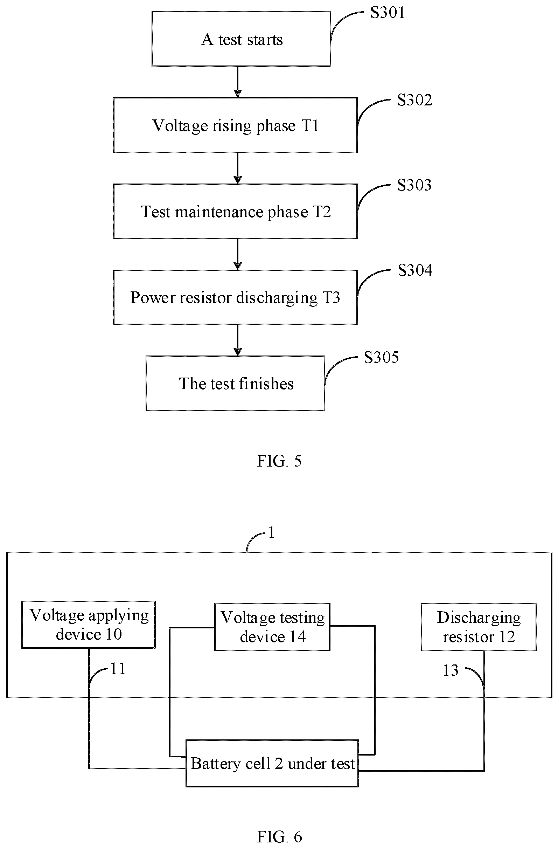

In this embodiment of this disclosure, after the direct-current voltage is applied to the battery cell under test, the direct-current voltage of the battery cell under test further needs to be decreased. The insulation withstand voltage testing on the battery cell under test of this time finishes only after the process of voltage applying and voltage decreasing. FIG. 5 is a schematic flow diagram of an example of an insulation withstand voltage testing process according to an embodiment of this disclosure. As shown in FIG. 5, the method includes the following steps.

Step S301: A test starts.

In this case, a voltage applying device starts to apply a voltage to a battery cell under test in response to a testing start signal.

Step S302: Voltage raising phase T1.

In this case, the voltage applying device applies a voltage, which gradually reaches a target voltage, to the battery cell under test in the time period T1.

Step S303: Test maintenance phase T2.

In this case, after applying the voltage of the target voltage to the battery cell under test, the voltage applying device maintains the target voltage for the time period T2.

Step S304: Power resistor discharging T3.

In this case, a discharging resistor discharges the battery cell under test in the time period T3, and decreases the voltage of the battery cell under test to zero.

Step S305: The test finishes.

In this embodiment of this disclosure, in the prior art, during insulation withstand voltage testing, a voltage needs to be gradually applied to the battery cell under test in the time period T1, then, after the voltage is raised to the target voltage, the target voltage is maintained for the time period T2, and finally, the voltage of the battery cell under test is decreased to zero in the time period T3. Compared with the prior art, in this solution, a current is tested in phase T1. Therefore, the voltage can be raised to the target voltage in relatively short duration, and compared with the prior art, duration of T1 is shortened by 60%. In addition, in this disclosure, the discharging resistor is configured to discharge the battery cell under test in the voltage decreasing phase T3. Therefore, the voltage of the battery cell under test can be decreased to zero in relatively short duration, and compared with the prior art, duration of T3 is shortened by 80%.

This embodiment of this disclosure provides an insulation withstand voltage testing method for a battery. The method includes: applying, by a voltage applying device, a direct-current voltage from a zero voltage to a target voltage to a battery cell under test in a first preset time period by using a voltage applying circuit in response to a testing start signal; obtaining a first current value that is generated by the battery cell under test based on the direct-current voltage in the first preset time period; continuously applying, by the voltage applying device, the direct-current voltage of the target voltage to the battery cell under test in a second preset time period by using the voltage applying circuit; obtaining a second current value that is generated by the battery cell under test based on the direct-current voltage in the second preset time period; and if the first current value is less than a first preset current threshold, and the second current value is less than a second preset current threshold, determining, by the voltage applying device, that a testing result of the battery cell under test is passing insulation withstand voltage testing of this time. By using the foregoing implementation solution, the current value that is generated by the battery cell under test based on the direct-current voltage is monitored in a process of applying a voltage to the battery cell under test, so that the voltage can be raised, in relatively short duration, to the target voltage required for a withstand voltage test, and voltage raising duration is reduced, thereby improving efficiency of insulation withstand voltage testing.

Based on the foregoing embodiments, an embodiment of this disclosure further provides an insulation withstand voltage testing system for a battery. As shown in FIG. 1, an insulation withstand voltage testing system 1 for a battery includes an insulation withstand voltage testing circuit and a voltage applying device 10. The insulation withstand voltage testing circuit includes a voltage applying circuit 11.

The voltage applying device 10 is connected to a test terminal corresponding to a battery cell 2 under test by using the voltage applying circuit 11.

The voltage applying circuit 11 is configured to: in response to a first testing signal, connect the voltage applying device 10 to the test terminal corresponding to the battery cell 2 under test.

The voltage applying device 10 is configured to: apply a direct-current voltage from a zero voltage to a target voltage to the battery cell under test in a first preset time period by using the voltage applying circuit in response to a testing start signal; obtain a first current value that is generated by the battery cell under test based on the direct-current voltage in the first preset time period; continuously apply the direct-current voltage of the target voltage to the battery cell under test in a second preset time period by using the voltage applying circuit; obtain a second current value that is generated by the battery cell under test based on the direct-current voltage in the second preset time period, where the second preset time period is a time period subsequent to the first preset time period; and if the first current value is less than a first preset current threshold, and the second current value is less than a second preset current threshold, determine that a testing result of the battery cell under test is passing insulation withstand voltage testing of this time.

In this embodiment of this disclosure, the first testing signal may be sent by an upper computer or a PLC to the voltage applying circuit 11. After receiving the first testing signal, the voltage applying circuit 11 is gated on. In this case, the voltage applying device 10 is connected to the test terminal corresponding to the battery cell 2 under test. The voltage applying device 10 applies a direct-current voltage from a zero voltage to a target voltage battery cell 2 under test in the first preset time period by using the voltage applying circuit 11 in response to the testing start signal; obtains the first current value that is generated by the battery cell 2 under test based on the direct-current voltage in the first preset time period; continuously applies the direct-current voltage of the target voltage to the battery cell 2 under test in the second preset time period by using the voltage applying circuit 11; obtains the second current value that is generated by the battery cell 2 under test based on the direct-current voltage in the second preset time period, where the second preset time period is a time period subsequent to the first preset time period; and if the first current value is less than a first preset current threshold, and the second current value is less than a second preset current threshold, determines that a testing result of the battery cell 2 under test is passing insulation withstand voltage testing of this time.

In this embodiment of this disclosure, when applying the direct-current voltage to the battery cell 2 under test, the voltage applying device 10 raises the direct-current voltage from zero to the target voltage based on the first preset time period. The first preset time period is duration required by the voltage applying device 10 for raising the direct-current voltage from zero to the target voltage. Due to an insulation withstand voltage characteristic of the battery cell 2 under test, a current of the battery cell 2 under test is extremely large when a relatively small direct-current voltage is provided for the battery cell 2 under test, and usually there is an instant current of an extreme value. Therefore, the first current value of the battery cell 2 under test needs to be monitored based on the first preset current threshold in a voltage raising process.

In this embodiment of this disclosure, after the direct-current voltage applied by the voltage applying device 10 to the battery cell 2 under test reaches the target voltage, namely, after the voltage raising phase finishes, the direct-current voltage of the target voltage is continuously applied to the battery cell 2 under test. The second preset time period is duration in which the voltage applying device 10 continuously provides the target voltage for the battery cell 2 under test, namely, is a voltage maintenance phase. In this case, the second current value of the battery cell 2 under test needs to be monitored in the voltage maintenance phase based on the second preset current threshold, where the first preset time period is less than the second preset time period.

FIG. 6 is a first schematic composition diagram of an example of an insulation withstand voltage testing system for a battery according to an embodiment of this disclosure. As shown in FIG. 6, in this embodiment of this disclosure, the insulation withstand voltage testing system 1 for a battery further includes a discharging resistor 12 and a voltage testing device 14. The insulation withstand voltage testing circuit further includes a discharging circuit 13. The discharging resistor 12 is connected to the test terminal corresponding to the battery cell 2 under test by using the discharging circuit 13. The voltage testing device 14 is connected to both ends of the battery cell 2 under test. The discharging circuit 13 is further configured to: in response to a second testing signal, connect the discharging resistor 12 to the test terminal corresponding to the battery cell 2 under test. The discharging resistor 12 is configured to discharge the battery cell 2 under test. The voltage testing device 14 is configured to test a voltage at both ends of the battery cell 2 under test.

In this embodiment of this disclosure, the second testing signal may be sent by an upper computer or a PLC to the discharging circuit 13 after it is determined that the voltage applying device 10 finishes applying the direct-current voltage to the battery cell 2 under test, that is, after the second preset time period finishes. After receiving the second testing signal, the discharging circuit 13 is gated on. In this case, the discharging resistor 12 is connected to the test terminal corresponding to the battery cell 2 under test, and the discharging resistor 12 discharges the target voltage in the battery cell 2 under test applied by the voltage applying device 10.

In this embodiment of this disclosure, after determining that the second preset time period finishes, the upper computer or the PLC may firstly send a cut-off signal to the voltage applying circuit 11. The voltage applying circuit 11 performs automatic cut-off when receiving the cut-off signal. In this case, a path between the voltage applying device 10 and the test terminal corresponding to the battery cell 2 under test is cut off, and then the second testing signal is sent to the discharging circuit 13 when the voltage applying circuit 11 is cut off.

In this embodiment of this disclosure, after receiving the second testing signal, the discharging circuit 13 is gated on, and the discharging resistor 12 is connected to the test terminal corresponding to the battery cell 2 under test. In this case, the discharging resistor 12 may discharge the target voltage in the battery cell 2 under test applied by the voltage applying device 10.

In this embodiment of this disclosure, a discharging time is related to a resistance value of the discharging resistor 12. A greater resistance value of the discharging resistor 12 indicates a shorter discharging time, and a smaller resistance value of the discharging resistor 12 indicates a longer discharging time. The resistance value of the discharging resistor 12 may be selected depending on an actual situation, and is not specifically limited in this embodiment of this disclosure.

It is understandable that, compared with the prior art of waiting for a voltage drop of the battery cell 2 under test that undergoes the withstand voltage test, in this embodiment of this disclosure, the discharging resistor 12 is configured to proactively discharge the battery cell 2 under test that undergoes the withstand voltage test, so that a voltage decreasing time can be reduced, and testing duration of the insulation withstand voltage testing is reduced, thereby improving efficiency of the insulation withstand voltage testing.

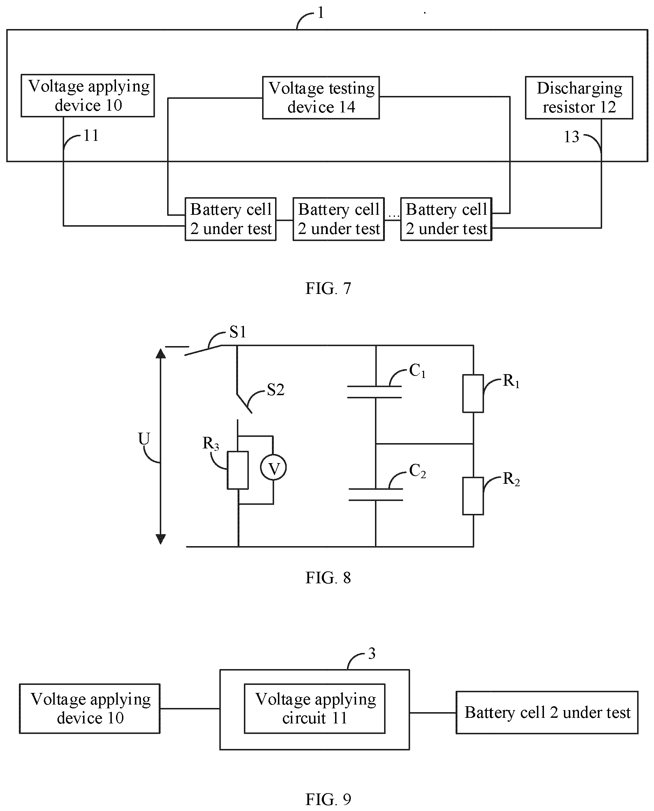

In this embodiment of this disclosure, the insulation withstand voltage testing system for a battery may perform insulation withstand voltage testing simultaneously on a plurality of battery cells under test. As shown in FIG. 7, when insulation withstand voltage testing is performed simultaneously on a plurality of battery cells 2 under test, the plurality of battery cells 2 under test needs to be connected in series. In this case, a target voltage and a discharging resistor 12 are determined based on a quantity of the battery cells 2 under test; and one discharging resistor 12 may be disposed for one battery cell 2 under test correspondingly, or only one discharging resistor 12 may be disposed for the plurality of battery cells 2 under test. A quantity of the battery cells 2 under test and a quantity of discharging resistors 12 may be determined depending on an actual situation, and are not specifically limited in this embodiment of this disclosure.

Based on the foregoing embodiments, this disclosure further provides an equivalent circuit diagram of performing insulation withstand voltage testing on a battery cell under test. As shown in FIG. 8, because each type of battery cell under test has dielectricity and resistivity, a battery cell under test in a circuit may be equivalent to a capacitor and a resistor connected in series. In other words, C₁ and R₁ are connected in series to replace one battery cell under test, and C₂ and R₂ are connected in series to replace another battery cell under test. Insulation withstand voltage testing starts, a relay S1 is closed, a relay S2 is cut off, and an insulation withstand voltage tester provides a direct-current voltage U for a circuit, and monitors a current of the circuit. The direct-current voltage U output by the insulation withstand voltage tester is raised from zero to a target voltage based on specific duration T1, the current is judged in a voltage raising process, and after the direct-current voltage U reaches the target voltage, the direct-current voltage U remains for a time period T2. At the same time, a current in the time period T2 is judged. Finally, the relay S1 is cut off, a relay S2 is closed, a power resistor R₃ is configured to discharge a voltage absorbed by the equivalent capacitor of the battery cell under test in the current, in which discharging lasts for T3, and a voltage regulator connected at both ends of the power resistor R₃ is configured to determine whether the voltage absorbed by the equivalent capacitor is decreased to zero.

Based on the foregoing embodiments, an embodiment of this disclosure further provides an insulation withstand voltage testing circuit. FIG. 9 is a schematic composition diagram of an insulation withstand voltage testing circuit according to an embodiment of this disclosure. As shown in FIG. 9, an insulation withstand voltage testing circuit 3 includes a voltage applying circuit 11.

One end of the voltage applying circuit 11 is connected to a voltage applying device 10, and the other end of the voltage applying circuit 11 is connected to a test terminal of a battery cell 2 under test. The voltage applying circuit 11, the voltage applying device 10, and the battery cell 2 under test form a circuit loop.

The voltage applying circuit 11 is configured to: in response to a first testing signal, connect the voltage applying device 10 to the test terminal corresponding to the battery cell 2 under test.

It is understandable that the voltage applying device 10 is configured to provide a direct-current voltage for the battery cell 2 under test.

In this embodiment of this disclosure, the voltage applying circuit 11 includes a voltage applying channel and a first switch array 111, and the voltage applying channel includes a first voltage applying channel 1100 and a second voltage applying channel 1101.

One end of the first voltage applying channel 1100 is connected to one end of the voltage applying device 10, and the other end of the first voltage applying channel 1100 is connected to a first test terminal 20 corresponding to a positive electrode of the battery cell under test.

One end of the second voltage applying channel 1101 is connected to the other end of the voltage applying device 10, and the other end of the second voltage applying channel 1101 is connected to a second test terminal 21 corresponding to a negative electrode of the battery cell under test.

The first switch array 111 is disposed on the first voltage applying channel 1100 and/or second voltage applying channel 1101.

In this embodiment of this disclosure, one end of the voltage applying device 10 is connected to the first test terminal 20 corresponding to the positive electrode of the battery cell under test by using the first voltage applying channel 1100 of the voltage applying circuit 11, and the other end of the voltage applying device 10 is connected to the second test terminal 21 corresponding to the negative electrode of the battery cell under test by using the second voltage applying channel 1101 of the voltage applying circuit 11.

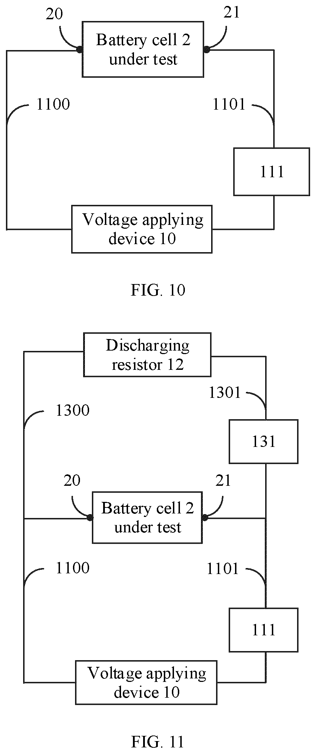

FIG. 10 is a first schematic composition diagram of an example of an insulation withstand voltage testing circuit according to an embodiment of this disclosure. As shown in FIG. 10, a voltage applying device 10 is connected to both ends of a battery cell 2 under test by using a first voltage applying channel 1100 and a second voltage applying channel 1101. When both the first voltage applying channel 1100 and the second voltage applying channel 1101 are gated on, the voltage applying device 10 provides a direct-current voltage for the battery cell 2 under test by using the first voltage applying channel 1100 and the second voltage applying channel 1101, to perform insulation withstand voltage testing on the battery cell 2 under test.

Still refer to FIG. 10, gating-on of the first voltage applying channel 1100 and/or second voltage applying channel 1101 is controlled by a first switch array 111, and there may be one or more switches in the first switch array 111.

In this embodiment of this disclosure, still refer to FIG. 10, a first control signal is sent by an upper computer or a PLC to the first switch array 111 in a voltage applying circuit 11. After the first switch array 111 connects, based on the first control signal, the voltage applying device 10 to a test terminal corresponding to the battery cell 2 under test, the upper computer or the PLC sends a testing start signal to the voltage applying device 10. After receiving the testing start signal, the voltage applying device 10 applies a direct-current voltage to the battery cell 2 under test by using the voltage applying circuit 11.

It is understandable that, still refer to FIG. 10, if there is one switch in the first switch array 111, the first switch array 111 may be disposed on the first voltage applying channel 1100 or the second voltage applying channel 1101. Only when the first switch array 111 is closed, can both the first voltage applying channel 1100 and the second voltage applying channel 1101 be gated on, and can the voltage applying device 10 provide a direct-current voltage for the battery cell 2 under test by using the first voltage applying channel 1100 and the second voltage applying channel 1101.

It is understandable that, still refer to FIG. 10, if there is a plurality of switches in the first switch array 111, the first switch array 111 may be disposed on each of the first voltage applying channel 1100 and the second voltage applying channel 1101. Only when switches included in the first switch array 111 are all closed, can both the first voltage applying channel 1100 and the second voltage applying channel 1101 be gated on, and can the voltage applying device 10 provide a direct-current voltage for the battery cell 2 under test by using the first voltage applying channel 1100 and the second voltage applying channel 1101.

In this embodiment of this disclosure, still refer to FIG. 10, if the first switch array 111 is disposed on the first voltage applying channel 1100, one end of the first switch array 111 is connected to one end of the voltage applying device 10, and the other end of the first switch array 111 is connected to a first test terminal 20 corresponding to a positive electrode of the battery cell under test. If the first switch array is disposed on the second voltage applying channel 1101, one end of the first switch array 111 is connected to the other end of the voltage applying device 10, and the other end of the first switch array 111 is connected to a second test terminal 21 corresponding to a negative electrode of the battery cell under test.

In this embodiment of this disclosure, the insulation withstand voltage testing circuit 3 further includes a discharging circuit 13.

One end of the discharging circuit 13 is connected to a discharging resistor 12, and the other end of the discharging circuit 13 is connected to the test terminal of the battery cell 2 under test. The discharging circuit 13, the discharging resistor 12, and the battery cell 2 under test form a circuit loop.

In this embodiment of this disclosure, the discharging resistor 12 is connected to both ends of the battery cell 2 under test by using the discharging circuit 13.

In this embodiment of this disclosure, the discharging circuit 13 includes a discharging channel and a second switch array 131. The discharging channel includes a first discharging channel 1300 and a second discharging channel 1301.

One end of the first discharging channel 1300 is connected to one end of the discharging resistor 12, and the other end of the first discharging channel 1300 is connected to the first test terminal 20 corresponding to the positive electrode of the battery cell under test.

One end of the second discharging channel 1301 is connected to the other end of the discharging resistor 12, and the other end of the second discharging channel 1301 is connected to the second test terminal 21 corresponding to the negative electrode of the battery cell under test.

The second switch array 131 is disposed on the first discharging channel 1300 and/or the second discharging channel 1301.

FIG. 11 is a second schematic composition diagram of an example of an insulation withstand voltage testing circuit according to an embodiment of this disclosure. As shown in FIG. 11, one end of a discharging resistor 12 is connected to a first test terminal 20 corresponding to a positive electrode of a battery cell under test by using a first discharging channel 1300 in a discharging circuit 13, and the other end of the discharging resistor 12 is connected to a second test terminal 21 corresponding to a negative electrode of the battery cell under test by using a second discharging channel 1301 in the discharging circuit 13.

In this embodiment of this disclosure, still refer to FIG. 11, the discharging resistor 12 is connected to both ends of the battery cell 2 under test by using the first discharging channel 1300 and the second discharging channel 1301. When both the first discharging channel 1300 and the second discharging channel 1301 are gated on, the discharging resistor 12 discharges, by using the first discharging channel 1300 and the second discharging channel 1301, a target voltage in the battery cell 2 under test applied by a voltage applying device 10.

In this embodiment of this disclosure, gating-on of the first discharging channel 1300 and the second discharging channel 1301 is controlled by a second switch array 131, and there may be one or more switches in the second switch array 131.

In this embodiment of this disclosure, a second control signal is sent by an upper computer or a PLC to the second switch array 131 in the discharging circuit 13. After the second switch array 131 connects, based on the second control signal, the discharging resistor 12 to a test terminal corresponding to the battery cell 2 under test, the discharging resistor 12 discharges the target voltage in the battery cell 2 under test applied by the voltage applying device 10.

It is understandable that, still refer to FIG. 11, if there is one switch in the second switch array 131, the second switch array 131 may be disposed on the first discharging channel 1300 or the second discharging channel 1301. Only when the second switch array 131 is closed, can both the first discharging channel 1300 and the second discharging channel 1301 be gated on, and can the discharging resistor 12 discharge, by using the first discharging channel 1300 and the second discharging channel 1301, the target voltage in the battery cell 2 under test applied by the voltage applying device 10.

It is understandable that, still refer to FIG. 11, if there is a plurality of switches in the second switch array 131, the second switch array 131 may be disposed on each of the first discharging channel 1300 and the second discharging channel 1301. Only when switches included in the second switch array 131 are all closed, can both the first discharging channel 1300 and the second discharging channel 1301 be gated on, and can the discharging resistor 12 discharge, by using the first discharging channel 1300 and the second discharging channel 1301, the target voltage in the battery cell 2 under test applied by the voltage applying device 10.

In this embodiment of this disclosure, still refer to FIG. 11, if the second switch array 131 is disposed on the first discharging channel 1300, one end of the second switch array 131 is connected to one end of the discharging resistor 12, and the other end of the second switch array 131 is connected to the first test terminal 20 corresponding to the positive electrode of the battery cell under test. If the second switch array 131 is disposed on the second discharging channel 1301, one end of the second switch array 131 is connected to the other end of the discharging resistor 12, and the other end of the second switch array 131 is connected to the second test terminal 21 corresponding to the negative electrode of the battery cell under test.

In this embodiment of this disclosure, after determining that a second preset time period finishes, the upper computer or the PLC may firstly send a cut-off signal to a first switch array 111 in a voltage applying circuit 11. The first switch array 111 performs automatic cut-off when receiving the cut-off signal. In this case, a path between the voltage applying device 10 and the test terminal corresponding to the battery cell 2 under test is cut off, and then a second testing signal is sent to the second switch array 131 in the discharging circuit 13 when the first switch array 111 is cut off, to connect the discharging resistor 12 to the test terminal corresponding to the battery cell 2 under test.

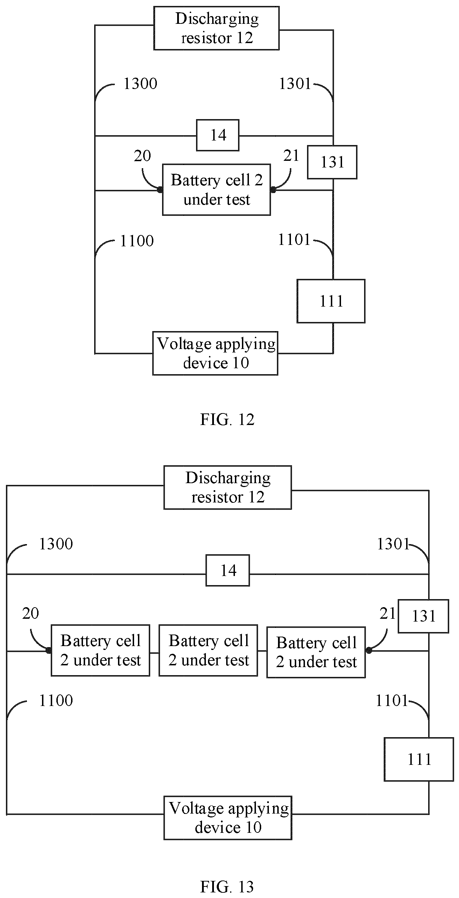

FIG. 12 is a third schematic composition diagram of an example of an insulation withstand voltage testing circuit according to an embodiment of this disclosure. As shown in FIG. 12, a voltage testing device 14 is connected to both ends of a battery cell 2 under test, and is configured to measure a voltage of the battery cell 2 under test in a discharging process. Assuming that the voltage testing device tests that the voltage of the battery cell 2 under test is zero, it indicates that discharging of the battery cell 2 under test finishes, and insulation withstand voltage testing of the battery cell 2 under test finishes.

In this embodiment of this disclosure, the insulation withstand voltage testing circuit may be connected to a plurality of battery cells 2 under test simultaneously, so that insulation withstand voltage testing is performed simultaneously on the plurality of battery cells 2 under test by using an insulation withstand voltage testing system 1 for a battery. FIG. 13 is a fourth schematic composition diagram of an example of an insulation withstand voltage testing circuit according to an embodiment of this disclosure. As shown in FIG. 13, when insulation withstand voltage testing is performed simultaneously on a plurality of battery cells 2 under test, the plurality of battery cells 2 under test needs to be connected in series. In this case, a target voltage and a discharging resistor 12 are determined based on a quantity of the battery cells 2 under test; and one discharging resistor 12 may be disposed for one battery cell 2 under test correspondingly, or only one discharging resistor 12 may be disposed for the plurality of battery cells 2 under test. A quantity of the battery cells 2 under test and a quantity of discharging resistors 12 may be determined depending on an actual situation, and are not specifically limited in this embodiment of this disclosure.

This embodiment of this disclosure provides an insulation withstand voltage testing system for a battery. The system includes an insulation withstand voltage testing circuit and a voltage applying device. The insulation withstand voltage testing circuit includes a voltage applying circuit. The voltage applying device is connected to a test terminal corresponding to a battery cell under test by using the voltage applying circuit. The voltage applying circuit is configured to: in response to a first testing signal, connect the voltage applying device to the test terminal corresponding to the battery cell under test. The voltage applying device is configured to: apply a direct-current voltage from a zero voltage to a target voltage to the battery cell under test in a first preset time period by using the voltage applying circuit in response to a testing start signal; obtain a first current value that is generated by the battery cell under test based on the direct-current voltage in the first preset time period; continuously apply the direct-current voltage of the target voltage to the battery cell under test in a second preset time period by using the voltage applying circuit; obtain a second current value that is generated by the battery cell under test based on the direct-current voltage in the second preset time period, where the second preset time period is a time period subsequent to the first preset time period; and if the first current value is less than a first preset current threshold, and the second current value is less than a second preset current threshold, determine that a testing result of the battery cell under test is passing insulation withstand voltage testing of this time. By using the foregoing implementation solution, the current value that is generated by the battery cell under test based on the direct-current voltage is monitored in a process of applying a voltage to the battery cell under test, so that the voltage can be raised, in relatively short duration, to the target voltage required for a withstand voltage test, and voltage raising duration is reduced, thereby improving efficiency of insulation withstand voltage testing.

It should be understood that "an embodiment" or "one embodiment" throughout the specification means that particular features, structures or characteristics associated with the embodiment is included in at least one embodiment of this disclosure. Therefore, "in an embodiment" or "in one embodiment" appearing throughout the specification does not necessarily refer to the same embodiment. Furthermore, the specific features, structures or characteristics may be combined in one or more embodiments in any suitable manner. It should be understood that in various embodiments of this disclosure, the serial numbers of the aforementioned processes do not imply the order of execution. The order of execution of the processes should be determined by their function and inherent logic, and should not constitute any limitation on the implementation processes of the embodiments of this disclosure. The above serial numbers of the embodiments of this disclosure are only for description and do not represent the advantages and disadvantages of the embodiments. It should be noted that the term "include", "comprise", or any of their variants are intended to cover a non-exclusive inclusion, so that a process, a method, an article, or a device that includes a list of elements not only includes those elements but also includes other elements that are not expressly listed, or further includes elements inherent to such process, method, article, or device. Without more constraints, an element preceded by "includes a..." does not preclude the presence of other identical elements in the process, method, article, or apparatus that includes the element.

In the several embodiments provided in this disclosure, it should be understood that the disclosed device and method may be implemented in other manners. The device embodiments described above are only schematic. For example, the division of the units may be only a logic function division, and in actual implementation, there may be another division manner. For example, multiple units or components may be combined, or may be integrated into another system, or some features can be ignored or not implemented. In addition, the coupling or direct coupling or communication connection between the displayed or discussed components may be through some interfaces, and the indirect coupling or communication connection of the device or unit may be electrical, mechanical, or in other forms.

The above-mentioned units described as separate components may or may not be physically separate, and the components displayed as units may or may not be physical units; that is, they may be located in one place or distributed to multiple network units. Some or all of the units may be selected according to actual needs to achieve the purpose of the solution of this embodiment. In addition, the functional units in the embodiments of this disclosure may all be integrated into one processing unit, or each unit may be separately used as a unit, or two or more units may be integrated into one unit. The above integrated unit can be implemented in the form of hardware, or in the form of hardware plus software functional units.

Those of ordinary skill in the art may understand that all or part of the steps to implement the above method embodiments may be completed by program instruction related hardware. The foregoing program may be stored in a computer-readable storage medium, and when the program is executed, the steps of the above method embodiments are performed. The foregoing storage medium includes: mobile storage devices, read-only memory (Read Only Memory, ROM), and various mediums that can store program codes such as magnetic disks or optical disks. Alternatively, if the integrated units of this disclosure are implemented in the form of software functional modules and sold or used as independent products, they can be stored in a computer-readable storage medium. Based on this understanding, the technical solution of this disclosure, in essence, or the portion that contributes to the prior art, can be reflected in the form of a software product, which is stored in a storage medium, including several instructions to enable a computer device (which can be a personal computer, server, or network device) to perform all or part of the steps of the methods described in various embodiments of this disclosure. The aforementioned storage medium includes: mobile storage devices, ROM, and various mediums that can store program codes such as magnetic disks or optical disks.

The above is only the implementation of this disclosure, but the protection scope of this disclosure is not limited to this, and variations or substitutions that any person skilled in the art can easily think within the technical scope disclosed in this disclosure should be covered by the protection scope of this disclosure.

### Industrial practicability

The embodiments of this disclosure provide an insulation withstand voltage testing method and system for a battery. A current value that is generated by a battery cell under test based on a direct-current voltage is monitored in a process of applying a voltage to the battery cell under test, so that the voltage can be raised, in relatively short duration, to a target voltage required for a withstand voltage test, thereby improving efficiency of insulation withstand voltage testing.

## Claims

1. An insulation withstand voltage testing method for a battery, comprising:
applying, by a voltage applying device, a direct-current voltage from a zero voltage to a target voltage to a battery cell under test in a first preset time period by using a voltage applying circuit in response to a testing start signal, and obtaining a first current value that is generated by the battery cell under test based on the direct-current voltage in the first preset time period;
continuously applying, by the voltage applying device, the direct-current voltage of the target voltage to the battery cell under test in a second preset time period by using the voltage applying circuit, and obtaining a second current value that is generated by the battery cell under test based on the direct-current voltage in the second preset time period, wherein the second preset time period is a time period subsequent to the first preset time period; and
if the first current value is less than a first preset current threshold, and the second current value is less than a second preset current threshold, determining, by the voltage applying device, that a testing result of the battery cell under test is passing insulation withstand voltage testing of this time;
wherein the voltage applying device is connected to a test terminal corresponding to the battery cell under test by using the voltage applying circuit, and the voltage applying circuit, the voltage applying device, and the battery cell under test form a circuit loop.

2. The insulation withstand voltage testing method according to claim 1, wherein the voltage applying circuit is configured to: in response to a first testing signal, connect the voltage applying device to the test terminal corresponding to the battery cell under test, so that the voltage applying circuit, the voltage applying device, and the battery cell under test form the circuit loop.

3. The insulation withstand voltage testing method according to claim 1 or 2, wherein:
the voltage applying circuit comprises a voltage applying channel and a first switch array, and the voltage applying channel comprises a first voltage applying channel and a second voltage applying channel;
one end of the first voltage applying channel is connected to one end of the voltage applying device, and the other end of the first voltage applying channel is connected to a first test terminal corresponding to a positive electrode of the battery cell under test;
one end of the second voltage applying channel is connected to the other end of the voltage applying device, and the other end of the second voltage applying channel is connected to a second test terminal corresponding to a negative electrode of the battery cell under test; and
the first switch array is disposed on the first voltage applying channel and/or the second voltage applying channel.

4. An insulation withstand voltage testing system for a battery, comprising an insulation withstand voltage testing circuit and a voltage applying device, wherein:
the insulation withstand voltage testing circuit comprises a voltage applying circuit;
the voltage applying device is connected to a test terminal corresponding to a battery cell under test by using the voltage applying circuit;
the voltage applying circuit is configured to: in response to a first testing signal, connect the voltage applying device to the test terminal corresponding to the battery cell under test; and
the voltage applying device is configured to:
apply a direct-current voltage from a zero voltage to a target voltage to the battery cell under test in a first preset time period by using the voltage applying circuit in response to the testing start signal;
obtain a first current value that is generated by the battery cell under test based on the direct-current voltage in the first preset time period;
continuously apply the direct-current voltage of the target voltage to the battery cell under test in a second preset time period by using the voltage applying circuit;
obtain a second current value that is generated by the battery cell under test based on the direct-current voltage in the second preset time period, wherein the second preset time period is a time period subsequent to the first preset time period; and
if the first current value is less than a first preset current threshold, and the second current value is less than a second preset current threshold, determine that a testing result of the battery cell under test is passing insulation withstand voltage testing of this time.

5. The insulation withstand voltage testing system according to claim 4, wherein:
the insulation withstand voltage testing system further comprises a discharging resistor and a voltage testing device, and the insulation withstand voltage testing circuit further comprises a discharging circuit;
the discharging resistor is connected to the test terminal corresponding to the battery cell under test by using the discharging circuit, and the voltage testing device is connected to both ends of the battery cell under test;
the discharging circuit is further configured to: in response to a second testing signal, connect the discharging resistor to the test terminal corresponding to the battery cell under test;
the discharging resistor is configured to discharge the battery cell under test; and
the voltage testing device is configured to test a voltage at both ends of the battery cell under test.

6. The insulation withstand voltage testing system according to claim 4 or 5, wherein:
one end of the voltage applying circuit is connected to the voltage applying device, and the other end of the voltage applying circuit is connected to the test terminal of the battery cell under test; and
the voltage applying circuit, the voltage applying device, and the battery cell under test form a circuit loop.

7. The insulation withstand voltage testing system according to claim 6, wherein:
the voltage applying circuit comprises a voltage applying channel and a first switch array, and the voltage applying channel comprises a first voltage applying channel and a second voltage applying channel;
one end of the first voltage applying channel is connected to one end of the voltage applying device, and the other end of the first voltage applying channel is connected to a first test terminal corresponding to a positive electrode of the battery cell under test;
one end of the second voltage applying channel is connected to the other end of the voltage applying device, and the other end of the second voltage applying channel is connected to a second test terminal corresponding to a negative electrode of the battery cell under test; and
the first switch array is disposed on the first voltage applying channel and/or the second voltage applying channel.

8. The insulation withstand voltage testing system according to claim 5, wherein:
one end of the discharging circuit is connected to the discharging resistor, and the other end of the discharging circuit is connected to the test terminal of the battery cell under test; and
the discharging circuit, the discharging resistor, and the battery cell under test form a circuit loop.

9. The insulation withstand voltage testing system according to claim 8, wherein:
the discharging circuit comprises a discharging channel and a second switch array, and the discharging channel comprises a first discharging channel and a second discharging channel;
one end of the first discharging channel is connected to one end of the discharging resistor, and the other end of the first discharging channel is connected to a first test terminal corresponding to a positive electrode of the battery cell under test;
one end of the second discharging channel is connected to the other end of the discharging resistor, and the other end of the second discharging channel is connected to a second test terminal corresponding to a negative electrode of the battery cell under test; and
the second switch array is disposed on the first discharging channel and/or the second discharging channel.
